Europäisches Patentamt

European Patent Office

Office européen des brevets

(19)

(11) **EP 0 942 289 A2**

(12) **EUROPEAN PATENT APPLICATION**

(43) Date of publication:
**15.09.1999 Bulletin 1999/37**

(51) Int Cl.6: **G01R 19/25**, G01R 35/00

(21) Application number: **99301713.6**

(22) Date of filing: **08.03.1999**

(84) Designated Contracting States:
**AT BE CH CY DE DK ES FI FR GB GR IE IT LI LU
MC NL PT SE**
Designated Extension States:
**AL LT LV MK RO SI**

(30) Priority: **10.03.1998 GB 9805034**

(71) Applicant: **Alstom UK Limited
Rugby, Warwickshire CV21 1TB (GB)**

(72) Inventor: **Hoole, Richard Steven
Wildwood, Stafford ST17 4RZ (GB)**

(74) Representative: **Dargavel, Laurence Peter
Alstom UK Limited,
PO Box 70,
Mill Road
Rugby, Warwickshire CV21 1TB (GB)**

(54) **Signal processing method and means**

(57)     A signal-processor, applicable especially to an analogue-to-digital conversion system, employs an inexpensive device (ADC 40) having a high temperature coefficient and enhances its temperature performance by, in an initial calibration phase, measuring the output of the device for a temperature-stable reference-signal (2V5) applied to its input and, in a subsequent measurement and compensation phase and at substantially the same ambient temperature, measuring the output for the same reference signal applied to the input and measuring the output for an input signal (Va) applied to the input. The digital input-signal reading is then corrected in dependence on a comparison of the two reference-signal readings which appeared at the output of the device. When used in a voltage- and current-measuring ADC arrangement, a stereo differential-input ADC unit (40) is advantageously employed together with voltage and current transformers (44, 45) having centre-tapped secondaries, the centre taps being fed from a signal related to the temperature-stable reference signal (2V5).

Fig.4.

## Description

The present invention relates to a signal processing means, in particular a signal processor comprising one or more analogue-to-digital converters for the measurement of an electrical quantity. The invention also relates to a method for compensating for a temperature sensitivity of an electronic device, in particular an analogue-to-digital converter.

Analogue-to-digital converters (ADC's) conventionally work on any of a number of known principles, two examples being the single-slope and the dual-slope conversion techniques. The latter tends to be a highly accurate device and has the advantage of being relatively immune to variations in the values or performance of the various components making up the converter, in particular the charging capacitor and charging-current generator, such variations being due largely to production spreads and the effect of temperature, but the disadvantage of being relatively slow due to the need to perform two ramping operations for each measurement cycle. The single-slope technique, which in practice is not commonly used, has the opposite characteristics, being fairly fast due to the presence of only a single ramp per cycle, but also very sensitive to factors such as the temperature sensitivity of the various converter components.

Other known techniques include the successive approximation technique and the sigma-delta technique. Successive approximation converters have reasonable resolution somewhat inferior to the dual-slope type, but are considerably faster. However, to achieve the accuracy of the dual-slope method together with a good temperature coefficient, considerable financial outlay is required. The sigma-delta types are an ideal combination of dual-slope and successive approximation techniques, achieving very high accuracy at good conversion speed. They are also very low-cost for the accuracy and speeds achieved. However, the temperature performance is set by the references used on the devices and, because these devices are largely used by the audio industry where poor temperature coefficient is not in itself a problem, manufacturers make do with poor-performance references to cut costs, so that the temperature stability of these devices is poor. In applications requiring stability of measurement, however, such corner-cutting can be a considerable drawback.

The present invention aims to provide a technique whereby an electronic device such as the sigma-delta ADC described above, which may have an inherently poor temperature coefficient, can achieve better temperature performance while maintaining acceptable performance in terms of speed, accuracy, etc.

In accordance with a first aspect of the invention there is provided a signal processor, comprising

an electronic device for processing an input signal, said device having an input means for receiving said input signal, an output means for delivering an output signal and a temperature-sensitive transfer function relating said output signal to said input signal, and

a processing means connected to said output means,

characterised by

switching means for switching said input means selectively between said input signal and a reference signal having a temperature-stable magnitude, and control means connected to said switching means, said control means in a calibration phase being arranged to apply said reference signal to said input means and said processing means being arranged to register a first value of a corresponding signal appearing at said output means, and

said control means in a measurement and compensation phase being arranged to apply said input signal to said input means, said processing means being arranged to register a second value of a corresponding signal appearing at said output means, and at substantially the same ambient temperature to apply said reference signal to said input means, said processing means being arranged to register a third value of a corresponding signal appearing at said output means, said processing means being arranged to compare said third value with said first value and to modify said second value in dependence on said comparison.

The processing means is preferably arranged to multiply said second value by a ratio of said first value to said third value.

The input means may be a differential input means comprising first and second inputs, said first and second inputs being supplied, in use, with said input and reference signals, selectively.

The reference signal may comprise first and second reference levels and said control means may be arranged to apply to said first and second inputs selectively an input signal, having as its common-mode reference level a signal related to said reference signal, and said first and second reference levels, said levels being applied to respective ones of said first and second inputs.

The device may be an analogue-to-digital converter.

The common-mode reference level and said first reference level may be the same level and said second reference level may equal a fraction thereof, for example one-half. The input signal may be provided by the centre-tapped secondary of a transformer, the centre tap being connected to said common-mode reference level.

The second reference level may be obtained by means of a temperature-stable potential divider connected across said first reference level.

The signal processor may comprise a pair of analogue-to-digital converters, the respective input signals thereof being provided through, on the one hand, a voltage transformer and, on the other hand, a current transformer.

The reference signal may advantageously have a temperature sensitivity significantly less than that of said transfer function.

In a second aspect of the invention, there is provided a method of compensating for a temperature sensitivity of an electronic device having an input means for receiving an input signal to be processed by said device, an output means for delivering an output signal and a temperature-sensitive transfer function relating said output signal to said input signal, the method being characterised by the steps of:

(1) in an initial calibration phase, applying a reference signal of temperature-stable magnitude to said input means and measuring a first value of a corresponding signal appearing at said output means;

(2) in a subsequent measurement and compensation phase,

(a) applying said input signal to said input means and measuring a second value of a corresponding signal appearing at said output means;

(b) at substantially the same ambient temperature, applying said reference signal to said input means and measuring a third value of a corresponding signal appearing at said output means;

(c) comparing said third value with said first value, and

(d) modifying said first value in dependence on said comparison,

wherein said steps 2(a) and (b) are in sequential forward or reverse order.

The calibration phase may take place at an ambient temperature for which said transfer function has a desired value.

Embodiments of the invention will now be described, by way of example only, with reference to the drawings, of which:

Figure 1 is a circuit diagram of an analogue-to-digital conversion arrangement in one embodiment of the invention;

Figure 2 is an arrangement as in Figure 2, in which the analogue-to-digital converter is a differential-input device;

Figure 3 shows a known analogue-to-digital conversion arrangement employing a dual differential-input analogue-to-digital device and a pair of differential amplifiers, and

Figure 4 shows a further embodiment of the invention similar to the arrangement of Figure 3, but without the differential amplifiers.

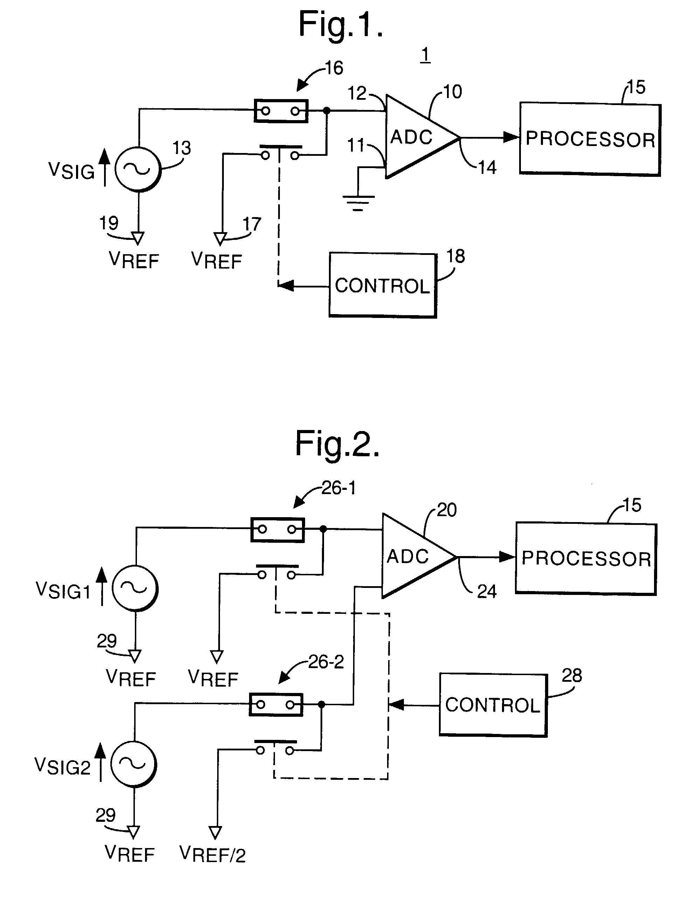

Referring now to Figure 1, Figure 1 shows a signal-processing arrangement 1 comprising a conventional non-dual-slope ADC 10, e.g. a sigma-delta converter, shown in this figure as a single-ended device, having a grounded first input 11 and a second input 12 which is supplied with an analogue signal, here an AC signal, 13. An output 14 of the ADC 10 passes on a digital representation of the analogue input signal to further processing equipment 15. The input signal 13 may be referenced to ground, if the ADC is capable of handling bipolar signals, or to a voltage level 19 higher than ground, if not. The converter 10 has a poor temperature coefficient, i.e. the transfer function relating the digital output to the analogue input is very sensitive to temperature fluctuations. Thus far there has been described a known ADC arrangement having a poor temperature performance.

The present invention improves the temperature characteristics of this known arrangement by interposing a changeover switching means 16 (which is preferably an analogue switch) between the signal source 13 and the ADC input 12 and by employing a corrective algorithm in the processing means 15. Switch 16 thus has its common terminal connected to the ADC input 12 and its two other terminals connected to the signal source 13 and a reference signal 17, respectively. The reference signal 17, which will normally be a DC voltage level, has a magnitude which has a very low sensitivity to temperature changes. Operation of the ADC arrangement is as follows:

Firstly, to calibrate the system, switch 16 is set so that input 12 of the ADC is supplied with the reference level 17, the processor means 15 then recording the digital value ($V_{outR1}$) corresponding to this reference level at the output of the ADC.

Thereafter, during normal use, switch 16 is changed over cyclically between its two states: in one state it is set so that the signal 13 is fed to the input 12 and a corresponding digital signal appears at the output 14 of the ADC. The value of this digital signal ($V_{outS}$) is recorded in the processing means 15. In its other state it feeds the reference level 17 to the input 12, the processor means 15 then recording the digital value ($V_{outR2}$) corresponding to this reference level at the output of the ADC.

The processing means 15 after each changeover operation performs the following calculation:

$$V'_{outS} = V_{outS} \cdot V_{outR1}/V_{outR2,}$$

where $V'_{outS}$ is the temperature-compensated digital value of the input signal $V_{sig}$ .

By operating the changeover switch and performing these measurements on a regular, cyclical basis, the digital output of the input signal 13 can be constantly corrected to correspond to the value it would have had at the original calibration temperature.

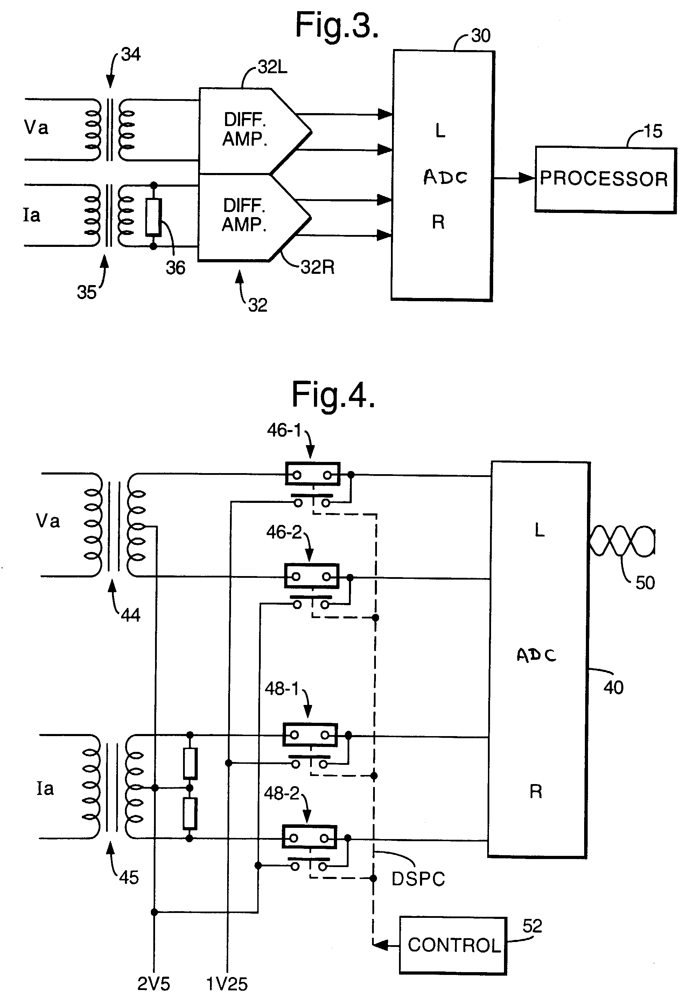

The switch 16 may be operated by a controller 18, whose possible principle of operation is described more fully below in relation to the embodiment shown in Figure 4. In practice, this control means may be part of the processing module 15, which will normally be realised as a microprocessor capable of controlling measurement operations, registering results and carrying out calculations to achieve temperature compensation.

The reference signal 17 is preferably the same DC level as the reference level $V_{ref}$ in order to minimise the effects of common-mode error in the ADC 10, though, where the common-mode rejection ratio of the ADC is sufficiently high, these two reference levels may be different. The reference level 19 should at all events, however, be derived from the reference level 17, or vice-versa, so that any temperature sensitivity of the system will result solely from the characteristics of the ADC, not additionally from the voltage source supplying the reference level 19.

The value $V_{outR1}$ derived during the calibration phase may be derived at any arbitrary temperature. While this ensures that the corrected digital values $V'_{outS}$ are relatively correct, i.e. correct between themselves, it does not guarantee that they will be correct in an absolute sense. The absolute accuracy of the digital outputs depends on the gain of the ADC at the calibration temperature, and therefore for maximum accuracy care should be taken that calibration takes place at a temperature at which ADC gain is as close to unity as possible; alternatively, some other value of gain may be considered to be the optimum, depending on the application.

It should be appreciated that the values $V_{outS}$ and $V_{outR2}$, which are constantly updated after the calibration phase, can be updated in either order, i.e. a new value of $V_{outS}$ first, then a new value of $V_{outR2}$, as described above, or vice-versa.

The invention can be applied equally well to electronic devices which have a differential input. Figure 2 shows such a device, the ADC 20, being fed with two signals $V_{sig1}$, $V_{sig2}$, through respective analogue switches 26-1, 26-2. Both of these signals are referenced to a temperature-stable DC level $V_{ref}$ shown at 29. The other changeover contact of the switch 26-1 is taken to the same reference level $V_{ref}$, while that of switch 26-2 is taken to a different reference value which is derived from the same temperature-insensitive source. In Figure 2 this different reference value is shown as $V_{ref/2}$, this being possibly derived by means of a potential divider across the primary reference source $V_{ref}$. There thus appears across the differential inputs of the ADC during the reference-measuring phase a voltage $V_{ref/2}$ which appears in digital form at the output 24 of the ADC as the signal $V_{outR1}$.

Switches 26-1 and 26-2 may again be controlled through a control means 28 implemented as part of the processor 15.

Compensation for temperature effects in this differential-input ADC arrangement is exactly the same as for the single-ended version shown in Figure 1 and will therefore not be further described here.

In many applications the input signals $V_{sig1}$, $V_{sig2}$ will be applied to the ADC via a differential amplifier having phase-splitting outputs and either a single-ended or double-ended input. Such an arrangement is illustrated in Figure 3, in which a dual differential-input ADC unit 30, having so-called "left" and "right" channels L and R respectively, is used to provide digital representations of the current and voltage in a power system, for example as part of a power-line relay apparatus. Feeding the differential input signals to the ADC pair is a corresponding pair 32L, 32R of differential amplifiers 32, these in turn being fed from the respective secondaries of transformers 34 and 35, transformer 34 being a voltage transformer for monitoring a power-line voltage Va and transformer 35 being a current transformer with burden resistor 36 for monitoring power-line current Ia. In practice three such arrangements would be employed, one for each phase of a 3-phase power system.

While the earlier-described temperature-coefficient improving technique when applied to the arrangement of Figure 3 would greatly enhance the performance of the ADC pair 30, it would not bring about any improvement in the temperature performance of the differential amplifiers 32. While these amplifiers may well have a lower temperature coefficient than the ADC pair 32 (depending on the specification of the latter), once the ADC temperature performance has been improved using the technique according to the invention, the residual temperature coefficient of the amplifiers may then dominate the performance of the whole arrangement.

In order to deal with this problem, the present invention dispenses with the differential amplifiers 32 and replaces transformers 34, 35 with equivalent units having a centre-tapped secondary. This is shown in Figure 4, which represents a concrete embodiment of the invention as used in a power-line relaying context. In this embodiment, the centre taps of transformers 44 and 45 are joined to a common line and taken to a temperature-stable 2.5v reference voltage 2V5, while the differential transformer outputs are taken to respective pairs of low-cost analogue changeover switches 46-1, 46-2; 48-1, 48-2, in a similar manner to the arrangement of Figure 2. As in Figure 2 also, the outputs of the switches are taken to respective differential inputs of the ADC pair 40, while the other changeover input of each switch is taken to a temperature-stable reference voltage source: in the case of switches 46-1 and 48-1 this voltage source is a 1.25v reference source 1V25, while in the case of switches 46-2 and 48-2 it is the same 2.5v source as is used to supply the centre taps.

The operation of this arrangement is exactly the same as for the arrangement of Figure 2, the two ADC's of the unit 40 functioning completely independently. Although not shown in Figure 4, the serial output 50 of the ADC pair 40 is taken to a processing means similar to that shown in Figure 2, in which the various voltage values appearing at the serial output are recorded and used to arrive at a compensated ADC output reading.

The switches 46, 48 are operated by a control means 52 which outputs a digital signal processor calibrate signal "DSPC" to initiate the reference-measuring phase of the present method. Thus this signal has two states, one corresponding to the reference-measuring phase, the other corresponding to the input-signal measuring phase.

In practice, this control means may be part of the processing means, which will normally be realised as a microprocessor capable of controlling measurement operations, registering results and carrying out calculations to achieve temperature compensation.

The embodiment shown in Figure 4 has been developed by the inventors using an economically priced 18-bit stereo sigma-delta ADC unit 40 (a dual-slope device was found to be too slow for the sample rate required) having a temperature coefficient of 0.2% per degree Centigrade. Using the present compensating technique, the temperature performance was improved by a factor of >25 times. The cost of this arrangement, in terms of hardware, was little more than the equivalent arrangement of Figure 3; the alternative solution, which was to use ADC's having a better specification, would have cost an order of magnitude more than this.

It will be appreciated that the performance of the enhanced ADC system described above depends largely on the stability of the reference source used. Ideally, the reference source should have a temperature stability at least ten times greater than the desired stability of the whole ADC arrangement, a requirement which will normally be found to be easily met with voltage sources available at the present time.

Although the description of the invention has focussed on an ADC signal-processing system, it may in practice be applied to any measurement system having an undesirably high temperature coefficient. Note also that, despite the fact that the input 13 in Figure 1 is shown as an AC signal, the present invention may equally be used to compensate for drifts in the conversion outputs of DC signals.

**Claims**

1. A signal processor comprising

   an electronic device (10) for processing an input signal (13), said device having an input means (12) for receiving said input signal, an output means (14) for delivering an output signal and a temperature-sensitive transfer function relating said output signal to said input signal, and
   a processing means (15) connected to said output means,

   characterised by

   switching means (16) for switching said input means (12) selectively between said input signal (13) and a reference signal (17) having a temperature-stable magnitude, and
   control means (18) connected to said switching means,
   said control means in a calibration phase being arranged to apply said reference signal to said input means and said processing means (15) being arranged to register a first value of a corresponding signal appearing at said output means (14), and
   said control means in a measurement and compensation phase being arranged to apply said input signal to said input means, said processing means being arranged to register a second value of a corresponding signal appearing at said output means, and at substantially the same ambient temperature to apply said reference signal to said input means, said processing means being arranged to register a third value of a corresponding signal appearing at said output means, said processing means being arranged to compare said third value with said first value and to modify said second value in dependence on said comparison.

2. A signal processor as claimed in Claim 1, wherein said processing means is arranged to multiply said second value by a ratio of said first value to said third value.

3. A signal processor as claimed in Claim 1 or Claim 2, wherein said input means is a differential input means comprising first and second inputs, said first and second inputs being supplied, in use, with said input and reference signals, selectively.

4. A signal processor as claimed in Claim 3, wherein said reference signal comprises first and second reference levels and said control means is arranged to apply to said first and second inputs selectively an input signal, having as its common-mode reference level a signal related to said reference signal, and said first and second reference levels, said levels being applied to respective ones of said first and second inputs.

5. A signal processor as claimed in Claim 4, wherein said device is an analogue-to-digital converter.

6. A signal processor as claimed in Claim 5, wherein said common-mode reference level and said first reference level are the same level and said second reference level equals a fraction thereof.

7. A signal processor as claimed in Claim 6, wherein said input signal is provided by the centre-tapped secondary of a transformer, the centre tap being connected to said common-mode reference level.

8. A signal processor as claimed in Claim 7, wherein said second reference level is obtained by means of a temperature-stable potential divider connected across said first reference level.

9. A signal processor as claimed in Claim 7 or Claim 8, wherein said fraction equals one-half.

10. A signal processor as claimed in any one of Claims 7 to 9, wherein said arrangement comprises a pair of analogue-to-digital converters, the respective input signals thereof being provided through, on the one hand, a voltage transformer and, on the other hand, a current transformer.

11. A signal processor as claimed in any one of the preceding claims, wherein said reference signal has a temperature sensitivity significantly less than that of said transfer function.

12. A method of compensating for a temperature sensitivity of an electronic device (10) having an input means (12) for receiving an input signal (13) to be processed by said device, an output means (14) for delivering an output signal and a temperature-sensitive transfer function relating said output signal to said input signal, the method being characterised by the steps of

(1) in an initial calibration phase, applying a reference signal of temperature-stable magnitude to said input means and measuring a first value of a corresponding signal appearing at said output means;
(2) in a measurement and compensation phase,

(a) applying said input signal to said input means and measuring a second value of a corresponding signal appearing at said output means;
(b) at substantially the same ambient temperature, applying said reference signal to said input means and measuring a third value of a corresponding signal appearing at said output means;
(c) comparing said third value with said first value, and
(d) modifying said first value in dependence on said comparison,

wherein said steps 2(a) and (b) are in sequential forward or reverse order.

13. Method as claimed in Claim 12, wherein said step 2(d) comprises the multiplication of said second value by a ratio of said first value to said third value.

14. Method as claimed in Claim 12 or Claim 13, wherein said device is a differential-input device and the method comprises the selective application of a differential input signal and a differential reference signal to said input means.

15. Method as claimed in Claim 14, wherein said differential input signal is derived by way of a transformer having a centre-tapped secondary, the signal appearing on said secondary being fed to said differential input means and the centre-tap being fed by a signal related to said reference signal.

16. Method as claimed in Claim 12, wherein said device is an analogue-to-digital converter.

17. Method as claimed in Claim 16, wherein said device comprises a pair of analogue-to-digital converters for the measurement of voltage and current in a circuit, said converters being fed from a pair of centre-tapped transformers, said transformers being fed at their primaries from a voltage source and a current source, respectively.

18. Method as claimed in claim 12, wherein said reference signal has a temperature sensitivity significantly less than that of said transfer function.

19. Method as claimed in claim 12, wherein said calibration phase takes place at an ambient temperature for which said transfer function has a desired value.

# Fig.1.

# Fig.2.

# Fig.3.

# Fig.4.